**Europäisches Patentamt**

(19) **European Patent Office**

**Office européen des brevets**

(11) Numéro de publication: **0 067 090**
**B1**

(12) # FASCICULE DE BREVET EUROPEEN

(45) Date de publication du fascicule du brevet:
27.02.85

(51) Int. Cl.⁴: **H 01 L 21/265, H 01 L 21/324**

(21) Numéro de dépôt: **82400883.3**

(22) Date de dépôt: **12.05.82**

(54) **Procédé de dopage de semi-conducteurs.**

(30) Priorité: **21.05.81 FR 8110132**

(43) Date de publication de la demande:
**15.12.82 Bulletin 82/50**

(45) Mention de la délivrance du brevet:
**27.02.85 Bulletin 85/9**

(84) Etats contractants désignés:
**CH DE GB LI**

(56) Documents cités:
**GB - A - 1 402 998**

**JAPANESE JOURNAL OF APPLIED PHYSICS, SUPPLEMENT, vol. 16, no. 16-1, 1977, pages 53-56, Tokyo (JP); H. ISHIWARA et al.: "Schottky barrier height control by using knock-on effect in ion implantation".**
**IBM TECHNICAL DISCLOSURE BULLETIN, vol. 23, no. 1, juin 1980, page 373, New York (USA); New York (USA); R.T. HODGSON: "Pulse ion implant and annealing".**
**IBM TECHNICAL DISCLOSURE BULLETIN, vol. 22, no. 9, février 1980, page 4107, New York (USA); M. BRISKA et al.: "Treating thin films by pulsed ion pmplantation".**
**NUCLEAR INSTRUMENTS & METHODS, vol. 182/183, part 1, avril/mai 1981, pages 85-92, Amsterdam (NL); A. GROB et al.: "Recoil implantation of antimony into silicon".**

(73) Titulaire: **COMMISSARIAT A L'ENERGIE ATOMIQUE Etablissement de Caractère Scientifique Technique et Industriel, 31/33, rue de la Fédération, F-75015 Paris (FR)**

(72) Inventeur: **Bruel, Michel, Lotissement Presvert No 9, F-38113 Veurey Voroise (FR)**
Inventeur: **Spinelli, Philippe, 24, rue Boileau, F-38700 La Tronche (FR)**

(74) Mandataire: **Mongrédien, André et al, c/o BREVATOME 25, rue de Ponthieu, F-75008 Paris (FR)**

## Description

La présente invention a pour objet un procédé de dopage de semi-conducteurs.

Dans la demande de brevet européenne EP.A.O. N° 033696, qui appartient à l'état de la technique, tel que défini à l'article 54, paragraphe 3, de la Convention européenne des brevets, il est décrit un procédé de dopage de semi-conducteurs dans lequel on réalise, dans l'ordre, les étapes suivantes:

— une implantation par recul des particules dopantes dans le substrat, qui consiste à déposer sur la surface du substrat une couche de matériau contenant des particules dopantes, et à bombarder ladite couche au moyen d'un faisceau de particules de bombardement, de façon à faire pénétrer les particules dopantes dans le substrat,

— une élimination de la couche de matériau déposée sur la surface du substrat,

— un recuit transitoire, qui consiste à apporter à la surface, ou au niveau des premières couches implantées, pendant un temps très bref, une densité d'énergie telle que de très hautes températures soient atteintes, de façon à produire une liquéfaction locale des premières couches du substrat. Les différentes étapes de ce procédé, peuvent être réalisées dans une même enceinte sous vide.

Dans ce procédé, la couche de matériau contenant les particules dopantes peut être réalisée par évaporation.

De plus, dans ce procédé la couche de matériau déposée sur le substrat peut être éliminée par pulvérisation ionique à l'aide d'un faisceau d'ions.

La présente invention a pour objet un perfectionnement à ce procédé de dopage de semi-conducteurs, permettant de diminuer la durée du dopage des semi-conducteurs, et donc d'obtenir à une cadence beaucoup plus rapide le dopage de semi-conducteurs de toutes sortes. Par ailleurs, le procédé selon l'invention présente une mise en œuvre simple et universelle.

De façon plus précise, la présente invention a pour objet un procédé de dopage de semi-conducteurs du genre de celui décrit précédemment, se caractérisant en ce que le bombardement de la couche de matériau contenant les particules dopantes déposées sur la surface du substrat, l'élimination de la couche dopante, après pénétration des particules dopantes dans le substrat, et le recuit transitoire sont réalisés dans le même temps au moyen du même faisceau de particules.

Selon un mode de mise en œuvre préféré de l'invention, le faisceau de particules de bombardement est constitué d'un faisceau d'ions de gaz rare, et notamment d'un faisceau d'ions d'argon.

L'utilisation du même faisceau de particules, et notamment d'un faisceau d'ions d'argon, permet de simplifier, par rapport au procédé de dopage de l'art antérieur, l'appareillage nécessaire pour réaliser le dopage de semi-conducteurs.

Selon un autre mode de mise en œuvre préféré de l'invention, le recuit transitoire peut être effectué soit en phase liquide, soit en phase solide.

D'autres caractéristiques et avantages de l'invention ressortiront mieux de la description qui va suivre, donnée à titre illustratif et nullement limitatif.

Le procédé de dopage de semi-conducteurs conformément à l'invention se présente sous différentes étapes que l'on va décrire, ces différentes étapes étant réalisées dans une même enceinte à vide.

La première étape est une implantation par recul qui consiste à faire pénétrer les particules dopantes (atomes ou ions) dans un substrat constitué du semi-conducteur à doper. Les particules dopantes sont contenues dans une couche de matériau déposée sur la surface du substrat, de préférence par évaporation. L'énergie nécessaire à la pénétration des particules dans le substrat, comprise entre quelques électrons-volts, et plusieurs kiloélectrons-volts provient d'un transfert d'énergie entre un faisceau de particules de bombardement, en particulier non dopantes, qui vient bombarder la couche déposée sur le substrat, et les particules dopantes contenues dans ladite couche.

En utilisant un faisceau d'ions de gaz rare très intense, tel que de l'argon, l'implantation par recul constitue une étape rapide du procédé.

La deuxième étape du procédé consiste à éliminer, après implantation, la couche de matériau déposée sur la surface du substrat. Selon l'invention, l'élimination de la couche se fait en utilisant un faisceau de particules qui est le même que celui utilisé pour l'implantation par recul. En particulier, ce faisceau de particules est un faisceau d'ions d'argon transportant la même énergie et présentant la même intensité que celui utilisé pour l'implantation par recul. La puissance du faisceau produit une élévation de température de la couche dopante qui se sublime ou s'évapore, réalisant ainsi la deuxième étape du procédé.

La troisième étape consiste à réaliser un recuit transitoire, permettant le positionnement des particules dopantes dans les sites interstitiels du réseau cristallin du substrat, et le réarrangement de ce réseau, perturbé lors de la pénétration des particules dopantes dans le substrat. Ce recuit transitoire consiste à apporter à la surface, ou au niveau des premières couches implantées, pendant un temps très bref, une densité d'énergie telle que de très hautes températures soient atteintes avec la possibilité d'obtenir une liquéfaction locale des premières couches du substrat. Ainsi, ce recuit transitoire peut se faire soit en phase liquide, soit en phase solide.

Selon la présente invention, ce recuit transitoire est effectué au moyen du même faisceau de particules que celui utilisé pour l'implantation par recul et pour l'élimination de la couche de matériau déposée sur le substrat. Ce faisceau de particules est, notamment, un faisceau d'ions d'argon, de même énergie et de même intensité que celui utilisé pour l'implantation par recul.

Les différentes étapes du procédé sont réalisées simultanément pendant l'irradiation par le faisceau d'ions; les trois étapes sont indiscernables et sont imbriquées temporellement.

On va maintenant donner un exemple de réalisation du procédé de dopage conformément à l'invention. Dans cet exemple de réalisation, le substrat à doper est en silicium et le matériau dopant est de l'antimoine.

On dépose tout d'abord sur une plaquette de silicium une couche mince d'antimoine, d'environ 60 nm (600 Å) d'épaisseur, par évaporation sous vide. Cette plaquette de silicium, disposée dans une enceinte à vide, est ensuite soumise à l'action d'un faisceau d'ions d'argon transportant chacun une énergie d'environ 200 keV et une intensité de 400 µA environ. La focalisation du faisceau d'ions sur la plaquette est effectuée par exemple sur une surface inférieure à 0,25 cm². Le bombardement par le faisceau d'ions de la plaquette se fait en balayant la totalité ou une partie de la surface de celle-ci.

Le bombardement de la plaquette s'accompagne d'une élévation de température. L'équilibre thermique est atteint au bout de quelques secondes. On constate alors que le dépôt d'antimoine a complètement disparu et que la partie irradiée de la plaquette présente un aspect cristallin.

Des mesures de la résistivité du semi-conducteur associées à des analyses par activation neutronique confirment qu'il y a bien eu dopage du substrat en silicium par l'antimoine.

L'exemple de réalisation décrit ci-dessus peut être interprété de la façon suivante.

Dans les premiers instants du bombardement de la plaquette par le faisceau d'argon, l'ensemble plaquette de silicium plus dépôt d'antimoine n'a pas eu le temps de chauffer. Dans ces premiers instants, la couche mince déposée est présente. L'effet du faisceau d'ions est donc de faire pénétrer par recul des atomes ou ions d'antimoine dans le substrat en silicium.

Dès que la température s'élève, sous l'action du faisceau d'ions, jusqu'à environ 500° C, la couche mince d'antimoine se sublime ou s'évapore, entraînant sa disparition.

Le faisceau d'ions continue alors d'apporter de l'énergie et donc de chauffer la plaquette. Celle-ci se trouve alors dans une gamme de températures où les couches superficielles altérées par l'implantation d'ions peuvent s'épitaxier à partir des couches profondes. Cette étape, correspondant au recuit transitoire, permet le réarrangement du réseau cristallin du semi-conducteur ainsi que la mise en site actif des atomes ou ions d'antimoine.

Le procédé de dopage selon l'invention, simple à mettre en œuvre et extrêmement rapide, peut être très intéressant pour la fabrication à grande échelle de cellules solaires à base de silicium.

## Revendications

1. Procédé de dopage de semi-conducteurs comprenant:

— une implantation par recul de particules dopantes dans le substrat, qui consiste à déposer sur la surface du substrat une couche de matériau contenant lesdites particules dopantes, et à bombarder ladite couche au moyen d'un faisceau de particules de bombardement, de façon à faire pénétrer les particules dopantes dans le substrat,

— une élimination de la couche de matériau déposée sur la surface du substrat,

— un recuit transitoire, qui consiste à apporter à la surface ou au niveau des premières couches implantées, pendant un temps très bref, une densité d'énergie telle que de très hautes températures soient atteintes, permettant une liquéfaction locale des premières couches du substrat, le bombardement de la couche de matériau contenant les particules dopantes déposées sur la surface du substrat pour obtenir la pénétration des particules dopantes dans le substrat, l'élimination de la couche dopante et le recuit transitoire étant réalisés dans le même temps au moyen du même faisceau de particules de bombardement.

2. Procédé de dopage selon la revendication 1, caractérisé en ce que le faisceau de particules est constitué d'un faisceau d'ions de gaz rare.

3. Procédé de dopage selon la revendication 2, caractérisé en ce que le faisceau d'ions de gaz rare est un faisceau d'ions d'argon.

4. Procédé de dopage selon la revendication 3, caractérisé en ce que le faisceau d'ions d'argon transporte une énergie d'environ 200 keV et présente une intensité d'environ 400 µA.

5. Procédé de dopage selon l'une des revendications 1 à 4, caractérisé en ce que le recuit transitoire est effectué en phase liquide.

6. Procédé de dopage selon l'une des revendications 1 à 4, caractérisé en ce que le recuit transitoire est effectué en phase solide.

## Patentansprüche

1. Verfahren zum Dotieren von Halbleitern, welches umfasst:

— Implantation durch Rückstoss von Dotierungsteilchen in dem Substrat, die darin besteht, dass auf der Substratoberfläche eine die Dotierungsteilchen enthaltende Materialschicht aufgebracht und diese Schicht mit einem Strahl von Bombardierungsteilchen derart beschossen wird, dass die Dotierungsteilchen in das Substrat eindringen,

— Entfernen der auf der Substratoberfläche aufgebrachten Materialschicht,

— Zwischenglühen, welches darin besteht, dass der Oberfläche oder auf der Höhe der ersten implantierten Schichten während einer sehr kurzen Zeitdauer eine Energiedichte zugeführt wird derart, dass sehr hohe Temperaturen erreicht werden, wodurch eine örtliche Verflüssigung der ersten Schichten des Substrats erreichbar ist, wobei das Beschiessen der die Dotierungsteilchen enthaltenden, auf der Substratoberfläche aufgebrachten Materialschicht, um das Eindringen von Dotierungsteilchen in das Substrat zu erhalten, das Entfernen der Dotierungsschicht und das Zwischenglühen während der gleichen Zeit mittels des gleichen Teilchenstrahls zum Beschiessen durchgeführt werden.

2. Dotierungsverfahren nach Anspruch 1, da-

durch gekennzeichnet, dass der Teilchenstrahl von einem Ionenstrahl eines Edelgases gebildet ist.

3. Dotierungsverfahren nach Anspruch 2, dadurch gekennzeichnet, dass der Edelgasionenstrahl ein Argonionenstrahl ist.

4. Dotierungsverfahren nach Anspruch 3, dadurch gekennzeichnet, dass der Argonionenstrahl eine Energie von etwa 200 keV transportiert und eine Intensität von etwa 400 µA aufweist.

5. Dotierungsverfahren nach einem der Ansprüche 1 bis 4, dadurch gekennzeichnet, dass das Zwischenglühen in flüssiger Phase durchgeführt wird.

6. Dotierungsverfahren nach einem der Ansprüche 1 bis 4, dadurch gekennzeichnet, dass das Zwischenglühen in fester Phase durchgeführt wird.

## Claims

1. Process for doping semiconductors comprising:

— implantation by embedding dopant particles in the substrate, which comprises depositing a layer of material containing said dopant particles on the surface of the substrate, and bombarding said layer by means of a beam of bombardment particles, thereby causing the dopant particles to penetrate into the substrate,

— elimination of the layer of material deposited on the surface of the substrate,

— transitory annealing, comprising exposing the surface, or the level of the first implanted layers, for a very brief time, to an energy density such that very high temperatures are attained, and permitting local liquefaction of the first layers of the substrate,

bombardment of the layer of material containing the dopant particles deposited on the surface of the substrate to obtain penetration of the dopant particles into the substrate, elimination of the dopant layer and the transitory annealing being carried out at the same time by means of the same beam of bombardment particles.

2. Doping process according to Claim 1, characterised in that the particle beam comprises a beam of noble gas ions.

3. Doping process according to Claim 2, characterised in that the beam of noble gas ions is a beam of argon ions.

4. Doping process according to Claim 3, characterised in that the beam of argon ions carries an energy of around 200 keV and has an intensity of around 400 µA.

5. Doping process according to one of Claims 1 to 4, characterised in that the transitory annealing is carried out in liquid phase.

6. Doping process according to one of Claims 1 to 4, characterised in that the transitory annealing is carried out in solid phase.